# EUROPÄISCHE PATENTANMELDUNG

(11) **EP 1 420 310 A2**
(43) Veröffentlichungstag der Anmeldung: **19.05.2004**
(21) Anmeldenummer: 03025800.8
(22) Anmeldetag: 11.11.2003
(51) Int. Cl.: G05B 19/418

(54) **Verfahren, Vorrichtung, computerlesbares Speichermedium und Computerprogramm-Element zum Überwachen eines Herstellungsprozess**

(30) Priorität: 12.11.2002 DE 10252613
(71) Anmelder: Infineon Technologies AG, 81669 München (DE)
(72) Erfinder: Märitz, Jörn, 93152 Zeiler-Nittendorf (DE); Steinkirchner, Erwin, 94315 Straubing (DE)
(74) Vertreter: Viering, Jentschura & Partner

(57) **Zusammenfassung**

Bei einem Verfahren zum Überwachen eines Herstellungsprozesses einer Mehrzahl von physikalischen Objekten werden mehrere Regeln gespeichert, welche mehreren Regeln sich auf zumindest einen Status mindestens eines der Mehrzahl von physikalischen Objekte beziehen. Ferner wird bei dem Verfahren unter Verwenden der mehreren Regeln eine Stichprobe aus der Mehrzahl von physikalischen Objekten ausgewählt, wobei physikalische Objekte der Stichprobe derart markiert werden, dass sie einer Messung unterzogen werden können, wobei die Regeln basierend auf dem Kriterium, dass die Anzahl von Messungen reduziert wird und redundante Messungen vermieden werden, ausgestaltet sind und wobei bei dem Verfahren die mehreren Regeln untereinander kombinierbar und gegeneinander abprüfbar.

## Beschreibung

Die Erfindung betrifft ein Verfahren, eine Vorrichtung, ein computerlesbares Speichermedium und ein Computerprogramm-Element zum Überwachen eines Herstellungsprozesses.

Bei der Herstellung von hochintegrierten Halbleiterchips auf Wafern werden insbesondere durch die immer weiter steigende Miniaturisierung der Strukturen auf dem Halbleiterchip immer höhere Anforderungen an die für die Herstellung der Halbleiterchips verwendeten Fertigungsanlagen und Herstellungsprozesse auftreten. Die Stabilität und Reproduzierbarkeit sowohl der Fertigungsanlagen als auch der Herstellungsprozesse beeinflussen maßgeblich die Ausbeute und Produktivität im Rahmen der Halbleiterchip-Fertigung. Schon kleine Abweichungen von einem Soll-Verhalten einer Wafer-Fertigungsanlage im Rahmen der Produktion können zu einer erheblichen Verschlechterung der Ausbeute, das heißt zu einer erheblichen Erhöhung der Fehlerrate bei den hergestellten Halbleiterchips führen.

Somit ist ein wesentlicher Aspekt bei der Herstellung von Halbleiterchips, mögliche Abweichungen von einem Soll-Verhalten bei einer Chip-Fertigungsanlage oder im Rahmen eines Herstellungsprozesses sehr frühzeitig zu erkennen und entsprechende Gegenmaßnahmen zu treffen. Damit kommt der Analyse und der Überwachung von Maschinen, insbesondere der Chip-Fertigungsanlagen sowie der Herstellungsprozesse eine sehr hohe wirtschaftliche Bedeutung zu. Ferner ist die Analyse und Überwachung vieler Prozessschritte des Herstellungsprozesses von erheblicher Bedeutung, da üblicherweise nur selten eine Reparatur eines Zwischenprodukts nach Durchführung eines Prozessschrittes möglich ist. In der Regel ist ein Funktionstest eines hergestellten Halbleiterchips erst ganz am Ende des Herstellungsprozesses vorgesehen, was zu einer sehr späten Rückkopplung der ermittelten Ergebnisse in den Herstellungsprozess führt.

Es ist weiterhin bekannt, in-line-Messungen von Prozess-Zwischenergebnissen, beispielsweise der Schichtdicken, des Schichtwiderstands oder von Linienbreiten, etc. mittels der sogenannten **S**tatistical **P**rocess **C**ontrol (SPC) vorzusehen. Dies führt jedoch zu zusätzlichen Messschritten im Rahmen des gesamten Herstellungsprozesses und ist somit zeit- und kostenaufwändig.

Im Rahmen des sogenannten **A**dvanced **P**rocess **C**ontrol (APC) werden Daten von internen und externen Sensoren der Fertigungsanlagen in Kombination mit eingesetzter Messtechnik inklusive in-line gemessener Daten an Zwischenprodukten, oder auch Ergebnissen von Messungen an Teststrukturen, nachdem der Wafer vollständig prozessiert worden ist, Ergebnissen von Funktionstests an den Halbleiterchips, der Ausbeute an fehlerfreien Halbleiterchips, etc., analysiert. Auf diese Weise kann sowohl die Stabilität der Fertigungsanlagen und auch die Prozessstabilität und auf diese Weise auch die Fertigungsproduktivität und die Produktqualität der hergestellten Halbleiterchips wesentlich erhöht werden.

Im Allgemeinen werden die Halbleiter-Chips zu mehreren auf so genannten Wafern hergestellt. Diese Wafer werden wiederum zu so genannten Losen gruppiert, in welchen eine Vielzahl von individuellen Wafern für eine weitere Behandlung der Wafer logistisch zusammengefasst werden und gemeinsam Halbleiter-Prozesschritten unterzogen werden.

Für in-line-Messungen von Prozess-Zwischenergebnissen im Rahmen der SPC werden Stichprobenauswahlen von Wafern eines Loses vorgenommen. An den ausgewählten Stichproben von Wafern werden dann Testmessungen durchgeführt, welche sich entweder auf die Qualität der Herstellungsschritte eines Herstellungsverfahrens oder auf die Qualität der hergestellten Produkte beziehen.

Gemäß dem Stand der Technik erfolgt die Stichprobenauswahl im Allgemeinen mittels so genannter händischer Regeln, d.h. es wird eine explizite, konkrete, einzelne Regel vorgegeben, an hand derer die Stichprobenauswahl durchgeführt wird. Dies kann entweder mittels Hantierungsanweisungen, d.h. Anweisungen, wie z.B. ganze Produktgruppen zu handhaben sind, geschehen, oder mittels expliziter Stopp-Anweisungen im Prozesslaufplan, welche ausgesuchte Lose an Wafern betreffen. Die Stichprobenauswahl wird getrennt nach einzelnen Prozessschritten durchgeführt.

Aus [1] ist ein System zum Verwalten der Qualitätskontrolle in einer Produktionsanlage zum Prozessieren von Losen von Erzeugnissen in Prozessieren für zumindest ein Produkt, welches System ein Herstellprozess und einen Statistical Process Control (SPC) Analysierer aufweist.

Aus [2]ist ein Prozess-Steuerungssystem bekannt, welches Vorwärtsteuerung Threads verwendet, welche auf Materialgruppen basieren, und welches Material Tracking verwendet, um die Variabilität des Prozessierens in einem Prozessablauf zu berücksichtigen.

Der Erfindung liegt das Problem zugrunde, eine Überwachung des Herstellungsprozesses zu vereinfachen und fehlerrobuster zu gestalten und dabei auch die Gefahr von Redundanz in den Messungen zu reduzieren.

Das Problem wird durch das Verfahren, die Vorrichtung, das computerlesbares Speichermedium und das Computerprogramm-Element zum Überwachen eines Herstellungsprozesses mit den Merkmalen gemäß den unabhängigen Patentansprüchen gelöst.

Bei einem Verfahren zum Überwachen eines Herstellungsprozesses einer Mehrzahl von physikalischen Objekten werden mehrere Regeln gespeichert, welche mehreren Regeln sich auf zumindest einen Status mindestens eines der Mehrzahl von physikalischen Objekte beziehen. Ferner wird bei dem Verfahren unter Verwenden der mehreren Regeln eine Stichprobe aus der Mehrzahl von physikalischen Objekten ausgewählt, wobei physikalische Objekte der Stichprobe derart markiert werden, dass sie einer Messung unterzogen werden können, wobei die Regeln basierend auf dem Kriterium, dass die Anzahl von Messungen reduziert wird und redundante Messungen vermieden werden, ausgestaltet sind und wobei bei dem Verfahren die mehreren Regeln untereinander kombinierbar und gegeneinander abprüfbar.

Die Vorrichtung zum Überwachen eines Herstellungsprozesses eines physikalischen Objektes weist mindestens einen Prozessor auf, der so eingerichtet ist, dass die oben beschriebenen Verfahrensschritte durchgeführt werden können.

In einem computerlesbaren Speichermedium ist ein Bearbeitungsprogramm zum Überwachen eines Herstellungsprozesses eines physikalischen Objektes gespeichert, welches Bearbeitungsprogramm, wenn es von einem Prozessor ausgeführt wird, die oben beschriebenen Verfahrensschritte aufweist.

Ein Computerprogramm-Element zum Überwachen eines Herstellungsprozesses eines physikalischen Objektes, weist die oben beschriebenen Verfahrensschritte auf, wenn es von einem Prozessor ausgeführt wird.

Die Erfindung kann sowohl mittels eines Computerprogramms, d.h. einer Software, als auch mittels einer oder mehrerer spezieller elektrischer Schaltungen, d.h. in Hardware oder in beliebig hybrider Form, d.h. mittels Software-Komponenten und Hardware-Komponenten, realisiert werden.

Vorteilhafterweise wird die Auswahl von Losen, welche einer Stichprobenuntersuchung unterzogen werden, der Anzahl von Wafern eines Loses, welche einer Stichprobenuntersuchung unterzogen werden, und eventuell auch die Auswahl der einzelnen Wafern, welche einer Testmessung zum Bestimmen der Qualität eines Produktionsschrittes unterzogen werden, mittels der Regeln automatisch gesteuert. Diese Regeln können global, d.h. für alle gleichartigen Lose gemeinsam, beeinflusst und/oder den jeweiligen Gegebenheiten angepasst werden. Dadurch ergibt sich eine einfacherer und fehlerresistentere Handhabung der Stichprobenauswahl für die Überwachung des Herstellungsprozesses.

Die Erfindung ist insbesondere im Rahmen der Halbleiter-Fertigung, d.h. beispielsweise bei der Herstellung von monokristallinem oder polykristallinem Silizium oder einem anderen Halbleitermaterial, oder auch der Halbleiterchip-Fertigung, d.h. im Rahmen der Herstellung von Halbleiterchips in einer Chip-Produktionsanlage, vorteilhaft einsetzbar. Es ist jedoch in diesem Zusammenhang darauf hinzuweisen, dass die Erfindung in jedem Produktionsverfahren vorteilhaft einsetzbar ist, insbesondere wenn viele Prozessschritte nötig sind, welche aufeinander abfolgen und welches Produktionsverfahren hinsichtlich der Qualität des Produktionsverfahrens und/oder der Qualität der Produkte zu überprüfen ist.

Unter einem Status eines Loses wird in der Anmeldung ein Zustand eines Loses verstanden, d.h. ein Wert eines logistischen Parameters unter dessen Verwendung weitere Prozessschritte gesteuert werden, und somit damit angegeben wird, wie das Los zu behandeln ist. Beispielsweise kann der Status ein Wert eines Speichers sein, wobei mittels des Wertes entsprechend nachfolgende Prozessschritte vorgegeben werden.

Unter einer Chip-Produktionsanlage ist in diesem Zusammenhang ein System bzw. eine Anordnung zu verstehen, in der unter Verwendung unterschiedlicher Rohmaterialien, beispielsweise unter Verwendung von Halbleiter-Materialien wie Silizium oder auch anderer IV-Hauptgruppen-Halbleiter-Materialien (beispielsweise Germanium) oder binären, ternären oder auch quaternären III-V-Verbindungshalbleiter-Materialien (beispielsweise Indium-Gallium-Arsenid-Phosphid, Indium-Gallium-Arsenid-Antimonid, etc.), oder binären, ternären oder auch quaternären II-VI-Verbindungshalbleiter-Materialien Halbleiter-Bauelemente, insbesondere Halbleiterchips gefertigt werden.

Unter einem Halbleiterchip ist im Rahmen dieser Beschreibung beispielsweise ein Speicher-Chip, ein Mikroprozessor-Chip, ein Kommunikations-Chip, ein Chip mit einem integrierten Halbleiter-Laser-Element, zu verstehen sowie ein auf eine beliebig vorgebbare Hardware-Funktion optimierter Chip wie beispielsweise ein Kommunikations-Chip zur Decodierung empfangener Funksignale oder ein Chip für die Verarbeitung von Videosignalen.

Die Chip-Produktionsanlage weist erfindungsgemäß mehrere Teil-Produktionsanlagen auf, beispielsweise unterschiedliche Maschinen, mit denen die für den gesamten Herstellungsprozess eines Chips notwendigen physikalischen oder chemischen Prozessschritte durchgeführt werden können.

Ein Beispiel insbesondere in dem Front-End-Bereich der Chip-Fertigung sind Vorrichtungen zum Durchführen der folgenden Prozessschritte:
- eine Kurzzeittemper-Vorrichtung (**R**apid **T**hermal **P**rocessing-Vorrichtung, RTP-Vorrichtung),
- ein Ofen zum Erhitzen der zu bearbeitenden Wafer,
- eine Ätzvorrichtung, beispielsweise eine Plasmaätz-Vorrichtung, oder eine Trockenätz-Vorrichtung,
- eine Lithographie-Vorrichtung,
- eine Nassbehandlungs-Vorrichtung zum Ätzen, Lackentfernen, Reinigen oder Verändern der Produkt-Oberfläche,
- eine CMP-Vorrichtung, d.h. eine Vorrichtung zum Durchführen chemisch-mechanischen Polierens,
- eine Ionen-Implantations-Vorrichtung,
- eine Abscheide-Vorrichtung zum Abscheiden von Schichten auf den Wafer, beispielsweise eine Abscheide-Vorrichtung zum physikalischen Abscheiden aus der Gasphase (**P**hysical **V**apour **D**eposition, PVD) oder zum chemischen Abscheiden aus der Gasphase (**C**hemical **V**apour **D**eposition, CVD),
- eine Messvorrichtung zum Messen vorgegebener Waferparameter oder Prozessparameter,
- eine Test-Vorrichtung zum Testen hergestellter Wafer.

Je nach dem jeweils herzustellenden Produkt, beispielsweise je nach gewünschter Ausgestaltung des zu fertigenden Chips, ist eine Vielzahl unterschiedlicher Vorrichtungen, das heißt Teil-Produktionsanlagen in der Chip-Produktionsanlage vorgesehen und miteinander gekoppelt zur Realisierung des jeweiligen notwendigen Gesamt-Halbleiterchip-Fertigungsprozesses.

Es ist in diesem Zusammenhang anzumerken, dass der Ablauf der einzelnen Prozessschritte in den jeweiligen Teil-Produktionsanlagen entweder "sequentiell", d.h. immer zuerst in einer ersten Anlagengruppe A (z.B. belacken) vor zweiten Anlagengruppe B (z.B. belichten) durchgeführt werden können für zwei Herstellungsschritte die nacheinander stattfinden sollen, oder "parallel", d.h. in einer ersten Anlage B1 (z.B. Scanner Typ XY100) oder einer zweiten Anlage B2 (z.B. Stepper Typ Extra2000) für zwei verschiede Anlagen und Prozesse, die alternativ ein und den selben Herstellungsschritt durchführen können.

Bevorzugte Weiterbildungen der Erfindung ergeben sich aus den abhängigen Ansprüchen. Die weiteren Ausgestaltungen der Erfindung betreffen das Verfahren und die Vorrichtung zum Überprüfen des Herstellungsprozesses eines physikalischen Objektes, das computerlesbare Speichermedium und das Computerprogramm-Element.

Vorzugsweise ist das physikalische Objekt ein Wafer.

Insbesondere bei der Waferherstellung mit ihrer extrem hohen Zahl von Prozessschritten und damit sehr hohen Anforderungen an die Genauigkeit der Einstellung der Prozessparameter eignet sich die Erfindung gut, da in diesem Bereich somit erstmals eine Überwachung der Produktqualität auf einfache Weise realisiert ist. Mittels der Erfindung kann die Anzahl an Testmessungen und die Anzahl von redundanten Messungen reduziert werden.

Eine der gespeicherten Regeln kann sich auf einen SPC-Samplingstatus beziehen. Vorzugsweise kann dies ein SPC-Samplingstatus wie z.B. "Jedes vierte Los von Produkt A muss gemessen werden" sein.

In einer Weiterbildung bezieht sich eine gespeicherte Regel auf eine Abfrage eines spezifischen Status des Loses, d.h. auf einen Status, welcher eine besondere Handhabung des Loses fordert. Dies kann z.B. ein so genannter "Blitzstatus" sein, welcher zur Folge hat, dass das so markierte Los nie gemessen wird.

Gemäß einer Ausgestaltung bezieht sich eine gespeicherte Regel auf eine Abfrage eines expliziten Status des Loses an einem Prozessschritt. Solch ein expliziter Status kann z.B. ein "Los an Operation xxx messen" oder "Los an Operation xxx nicht messen" sein.

Gemäß einer Weiterbildung bezieht sich eine gespeicherte Regel auf eine Abfrage eines Samplingstatuses des Loses, d.h. auf einen Status, welcher sich auf vorhergehende Prozessschritte oder Messungen bezieht, z.B. ein Status "wenn ein Los an der Operation xxx nicht gemessen, dann dieses Los an Operation yyy auch nicht messen".

Eine gespeicherte Regel kann sich auf eine Abfrage eines Sonderüberwachungsstatus beziehen. Solch ein Sonderüberwachungsstaus kann z.B. ein Status wie "von Produkt A auf Operation xxx immer mit Programm nnn 3 Wafer messen" sein.

Vorzugsweise sind die verschiedenen gespeicherten Regeln miteinander kombiniert, d.h. sie beeinflussen sich gegenseitig und/oder werden gegeneinander abgeprüft.

Ferner Vorzugsweise werden die markierten physikalischen Objekte einer Messung unterzogen.

Anschaulich kann die Erfindung darin gesehen werden, dass die Erfindung eine automatisierte Auswahl von Stichproben mittels methodischer Anwendung von Regeln schafft. Es können verschiedene Arten von Regeln hinterlegt werden, z.B. so genannte händische Regeln, d.h. Regeln welche explizite Einzelanweisungen sind, oder automatische Regeln, d.h. Regeln in der Art von z.B. "Wenn Messung A an einem Los erfolgt ist, dann auch Messung B an diesem Los durchführen". Mittels eines erfindungsgemäßen Verfahrens wird ein automatisches Regelwerk, d.h. ein Verzeichnis mehrerer sich wechselseitig beeinflussender Regeln geschaffen. Dieses automatische Regelwerk ist flexibel aufgebaut und kann ohne Probleme erweitert werden, wenn der Herstellungsprozess oder die Überwachung des Herstellungsprozesses dies erfordern.

Mittels der Erfindung wird ein Satz von Auswahlregeln geschaffen, welche eine Stichprobenauswahl für Testmessungen einer Überprüfung des Herstellungsprozesses bereitstellen. Die Auswahl von Losen, von der Anzahl von Wafern, welche gemessen werden sollen, und eventuell der Wafernummern wird automatisch geregelt. Die Regeln werden global, d.h. für verschiedene Produktionsschritte gleichzeitig und nicht separat für jeden einzelnen Prozessschritt beeinflusst oder angepasst. Verschiedene Regeln werden gegeneinander geprüft, so dass es nicht zu redundanten Messungen kommen kann, d.h. die Anzahl an kosten- und zeitintensiven Messungen wird verringert. Zusätzlich wird mittels des Abprüfens der Regeln gegeneinander verhindert, dass Messungen nicht durchgeführt werden, d.h. es kann nicht dazu kommen, dass Messungen vergessen werden und so eine notwendige Produktüberwachung der einzelnen Wafer nicht durchgeführt wird.

Vorzugsweise weist das Regelwerk einen Mindestsatz von fünf Regeltypen auf, von denen sich ein Regeltyp auf eine Abfrage eines SPC-Samplingstatus bezieht, ein Regeltyp auf eine Abfrage eines Losstatus bezieht, ein Regeltyp auf eine Abfrage eines expliziten Losstatus an einer Operation bezieht, ein Regeltyp auf eine Abfrage des Samplingstatuses eines Loses bezieht und ein Regeltyp auf eine Abfrage eines Sonderüberwachungsstatus bezieht.

Auch wenn die Erfindung im Weiteren an dem Beispiel eines Überwachungsverfahrens eines Wafer-Herstellungsverfahrens näher erläutert wird, ist darauf hinzuweisen, dass die Erfindung nicht darauf beschränkt ist, sondern in allen Überwachungsverfahren für Herstellungsverfahren, bei welchen im Herstellungsverfahren zum Herstellen eines physikalischen Objekts Prozessparameter aufgenommen werden, eingesetzt werden kann, beispielsweise auch in der Pharma-Industrie bei dem Herstellen von pharmazeutischen Produkten.

Ein Ausführungsbeispiel der Erfindung ist in den Figuren dargestellt und wird im Weiteren näher erläutert.

Es zeigen:
Figur 1 ein Blockdiagramm, in welchem die allgemeine Organisation einer Chip-Produktionsanlage dargestellt ist;
Figur 2 eine Skizze einer Chip-Produktionsanlage, wobei der komplexe Materialfluss, d.h. der Weg eines Wafers/Loses durch die Chip-Produktionsanlage und die damit vorhandenen komplexen Prozessschritte dargestellt ist;
Figur 3 ein Blockdiagramm, in dem der Prozessdatenfluss bei dem Herstellen eines Wafers/Loses dargestellt ist; und
Figur 4 einen schematischen Programmablaufplan eines Verfahrens gemäß einem Ausführungsbeispiel der Erfindung.

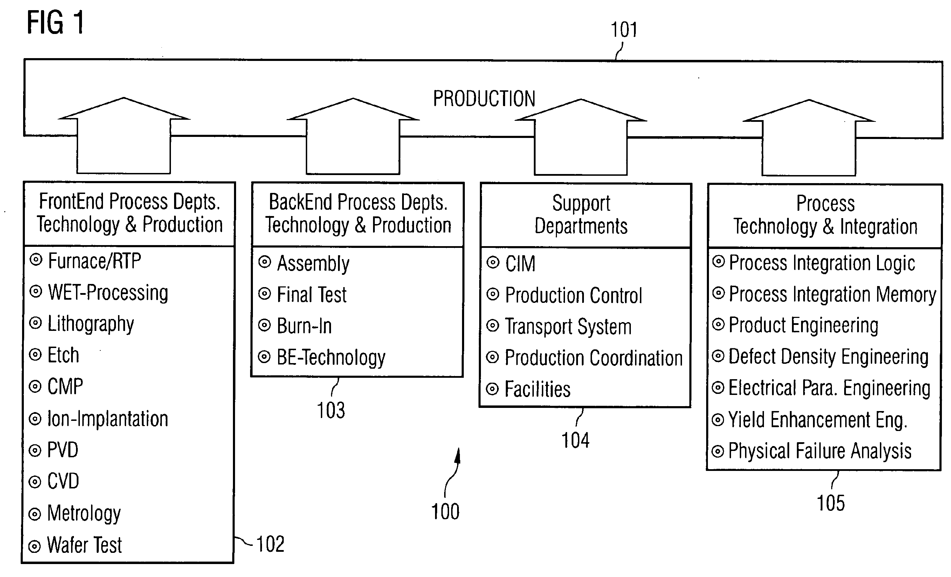

Einleitend wird in **Fig. 1** in einem Blockdiagramm 100 schematisch die Organisation und der Aufbau einer Halbleiterchip-Produktionsanlage erläutert, für welche ein erfindungsgemäßes Verfahren zum Überwachen eines Herstellungsprozesses einer Mehrzahl von Wafern verwendet werden kann, auf welchen Wafern die Halbleiterchips angeordnet sind.

Der gesamte Herstellungsprozess, in Fig. 1 mit einem ersten Block 101 bezeichnet, wird beispielhaft in vier Produktionsbereiche 102, 103, 104, 105 gruppiert,
einen ersten Bereich, in den die Front-End-Prozesse der Chip-Fertigung gruppiert werden (Block 102),
einen zweiten Bereich des Herstellungsprozesses, in den die Back-End-Prozesse gruppiert werden (Block 103),
einen dritten Bereich des Herstellungsprozesses, der den Support betrifft, das heißt die Unterstützung der einzelnen Herstellungsprozesse (Block 104),
ein vierter Bereich der die Prozesstechnologie und die Prozessintegration betrifft (Block 105).

Bei den Front-End-Prozessen 102 sind insbesondere folgende Prozesstechnologien sowie die für die Durchführung der entsprechenden Prozesse eingerichteten Vorrichtungen vorgesehen:
Ein Ofen zum Erhitzen des jeweiligen zu prozessierenden Wafers,
eine Vorrichtung zum Durchführen eines Kurzzeit-Temperverfahrens (Rapid Thermal Processing, RTP),
eine Vorrichtung zum Ätzen des Wafers, beispielsweise zum Nassätzen oder zum Trockenätzen,
eine Vorrichtung zum Reinigen, beispielsweise Waschen des Wafers,
eine Vorrichtung zur Durchführung unterschiedlicher Lithographieschritte,
eine Vorrichtung zum chemisch-mechanischen Polieren (Chemical Mechanical Polishing, CMP),
eine Einrichtung zur Durchführung einer Ionen-Implantation in vorgegebenen Bereichen des Wafers bzw. des jeweils zu fertigenden Chips,
Vorrichtungen zum Aufbringen von Materialien auf dem Wafer, beispielsweise Vorrichtungen zum Abscheiden von Materialien aus der Gasphase, das heißt beispielsweise Vorrichtungen zum Durchführen von Physical Vapour Deposition (PVD) oder Chemical Vapour Deposition (CDV), oder eine Vorrichtung zum epitaktischen Aufwachsen von Material auf einem Substrat, Metrologie-Vorrichtungen, d.h. Messvorrichtungen,
Vorrichtungen zum Durchführen von Tests auf den jeweiligen Wafern.

Die Back-End-Prozesse betreffen insbesondere folgende Bereiche:
Den Zusammenbau der Chips in Gehäuse,
den Endtest des gefertigten und gehäusten Chips,
das Einbringen von Informationen, beispielsweise Produktinformation, in oder an das Gehäuse des jeweiligen Chips, sowie
allgemein die im Bereich des Back-Ends für gehäuste und ungehäuste Chip eingesetzten Technologien.

Der Support, das heißt die Prozessunterstützung betrifft insbesondere folgende Bereiche:
CIM,
Prozessüberwachung,
ein Transportsystem zur Auslieferung der gefertigten Halbleiterchips,
eine Koordination der Produktion,
die Unterstützung der jeweiligen Fertigungsstandorte.

Die Prozesstechnologie und die Prozessintegration betrifft insbesondere
die Prozessintegration von Logikbausteinen,
die Prozessintegration von Speicherbausteinen,
das Produkt-Engineering,
das Überwachen und Verbessern von Fehlerdichten bei der Herstellung,
das Überwachen elektrischer Parameter bei den hergestellten Produkten,
die Verbesserung der Ausbeute der hergestellten Chips,
eine physikalische Fehleranalyse.

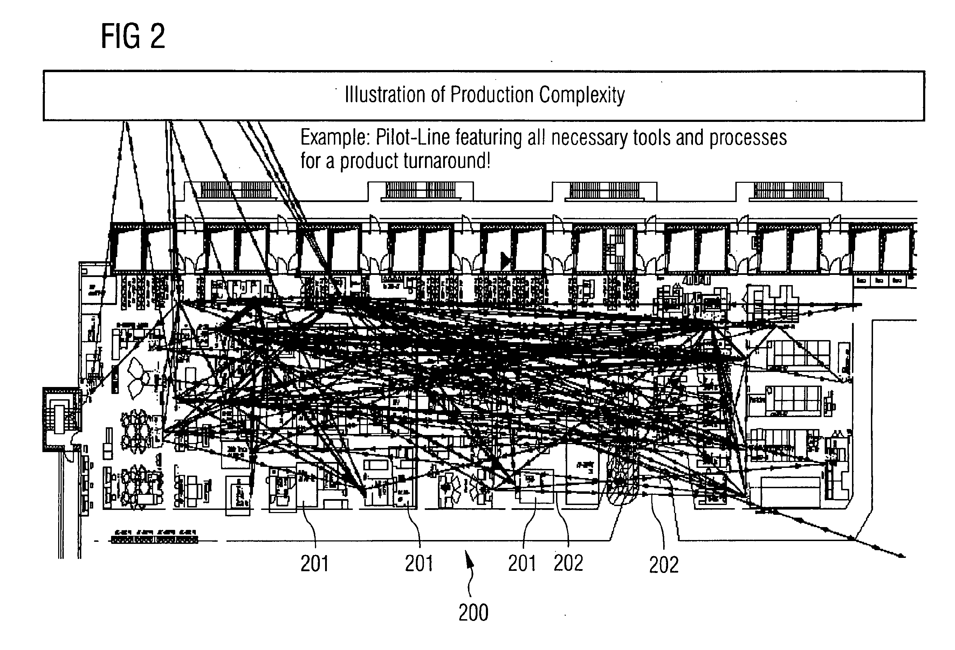

**Fig. 2** zeigt eine Halbleiterchip-Produktionsanlage, anders ausgedrückt eine Halbleiterchip-Fabrik 200 mit einer Vielzahl von Halbleiterchip-Teil-Produktionsanlagen 201, welche eingesetzt werden zur Bearbeitung von Rohmaterialien, beispielsweise eines Siliziumwafers oder eines Wafers aus anderen Halbleiter-Materialien (Germanium, Gallium-Arsenid, Indium-Phosphid, etc.), um aus den Rohmaterialien Halbleiterchips zu fertigen.

Ein üblicher Herstellungsprozess zur Herstellung eines Halbleiterchips weist Hunderte von unterschiedlichen Prozessschritten auf, bei denen in unterschiedlicher Reihenfolge Lithographieschritte, Ätzschritte, CMP-Schritte, Schritte des Aufbringens von Materialien auf dem jeweiligen zu prozessierenden Wafer, oder auch Dotierungs- oder Implantationsschritte von Dotierungsatomen in den zu prozessierenden Wafer durchgeführt werden.

Somit ergeben sich die in Fig. 2 durch Linien 202 dargestellten Wege, welche den Weg eines Wafers oder eines Loses von Wafern durch die Halbleiterchip-Produktionsanlage 200 darstellen. In der Halbleiterchip-Produktionsanlage 200 ist eine Vielzahl von Sensoren, welche den jeweiligen Teil-Produktionsanlagen 201 zugeordnet sind und eine noch größere Menge von Prozessdaten werden aufgenommen, welche jeweils von den Sensoren erfasst werden. Ein jeweiliger Sensor kann in eine jeweilige Maschine integriert sein (integrierter Sensor) oder separat an eine jeweilige Maschine angebaut sein (externer Sensor).

Im Weiteren werden die Teil-Produktionsanlagen 201 auch als Maschinen 201 bezeichnet.

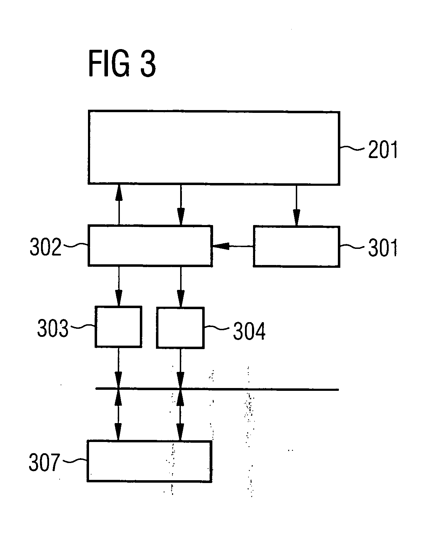

**Fig.3** zeigt beispielhaft den Datenfluss für Prozessdaten, welche an einer Maschine 201 mittels eines integrierten oder mittels eines externen Sensors 301. Jeder Sensor 301, wobei eine beliebige Anzahl integrierter und/oder externer Sensoren vorgesehen sein können, erfasst die jeweils für ihn vorgegebenen Parameter der Maschine 201, beispielsweise physikalische oder chemische Zustände in einer Prozesskammer, die Position eines Roboterarms, etc. Beispiele für Prozessparameter bei der Herstellung eines Wafers sind zum Beispiel die Dejustierung, d.h. die PositionierungsUngenauigkeit, innerhalb eines Positionierungsschrittes, Temperatur während eines Prozessschrittes, Gasfluss während eines Prozessschrittes, Zeitdauer eines Prozessschrittes oder der Druck während eines Prozessschrittes.

Der Sensor 301 ist über eine SECS-Schnittstelle 302, die eingerichtet ist zur Datenkommunikation gemäß den SECS-Standards mit einem lokalen Kommunikationsnetz (Local Area Network, LAN) 306 gekoppelt.

Gemäß den SECS-Standards werden von dem Sensor 301 und der SECS-Schnittstelle 302 Dateien gemäß dem PDSF-Format (Process Data Standard Format) erzeugt, im Weiteren auch bezeichnet als PDSF-Dateien 303 sowie Protokolldateien 304, wobei die PDSF-Dateien 303 und die Protokolldateien 304 als Daten in einem Speicher 307 gespeichert werden.

Die PDSF-Dateien 303 enthalten z.B. analoge Daten von unterschiedlichen Kanälen, das heißt von unterschiedlichen internen (d.h. integrierten) und/oder externen Sensoren 301, welche an einer Maschine 201 angebracht sein können. Die erzeugten Prozessdaten werden in dem Speicher 307 gespeichert.

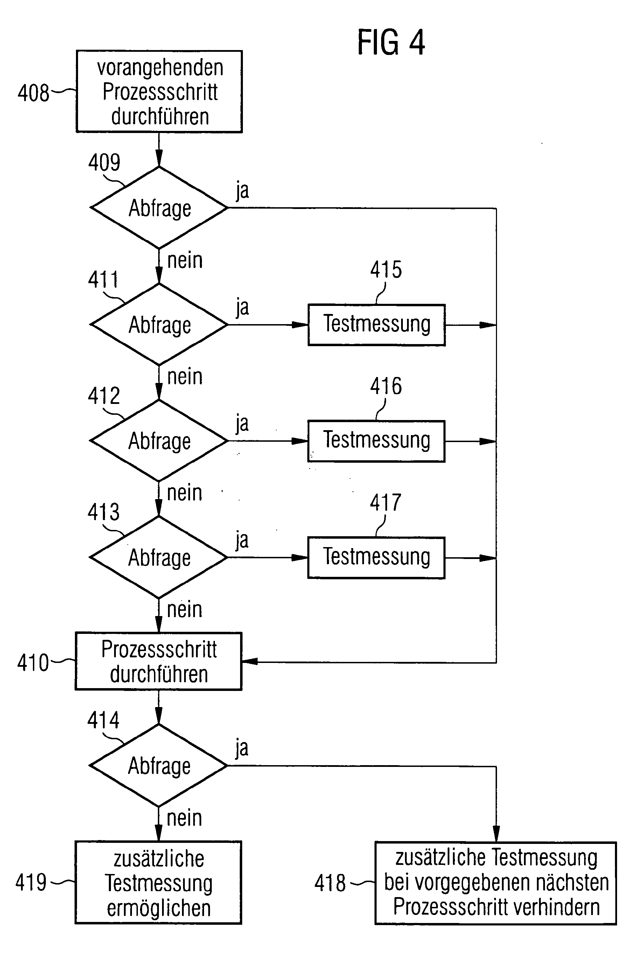

Nachdem in den Figuren 1 bis 3 eine schematische Übersicht über einen Herstellungsprozess eines Wafers dargestellt wurde, wird in **Fig. 4** nun ein schematischer Ablaufplan eines Verfahrens zum Überwachen eines derartigen Herstellungsprozesses gemäß einem Ausführungsbeispiel der Erfindung gegeben.

Das Auswerten der erzeugten Prozessdaten und/oder anderer Daten, wie z.B. Statusinformationen einzelner Lose von Wafern, für das Überwachen des Herstellungsprozesses wird mittels eines Steuerrechners durchgeführt.

Ausgehend von einer vorangehenden Operation oder einem vorangehenden Prozessierungsschritt 408 im oben beschriebenen Herstellungsprozess werden im Ablaufplan gemäß einem Ausführungsbeispiel der Erfindung die automatischen Regeln der Stichprobenauswahl durchlaufen. Hierzu werden mittels des Steuerrechners für die einzelnen Wafer oder Lose von Wafern die aufgenommenen und gespeicherten Informationen gemäß vorgegebener Regeln ausgewertet. Bei der Auswertung mittels des Steuerrechners wird anhand der gespeicherten Informationen, d.h. Prozessdaten oder für einen einzelnen Wafer oder ein Los von Wafern hinterlegten Statusinformationen, die Stichprobenauswahl durchgeführt.

Eine erste Regel 409, aufgrund derer mittels des Steuerrechners eine Stichprobenauswahl für Testmessungen an mittels des oben beschriebenen Herstellungsprozesses hergestellten Wafern oder Losen von Wafern getroffen wird, bezieht sich auf die Abfrage eines so genannten Losstatus, d.h. einen Status, in welchem eine Variable, welche dem Los zugewiesen wird, einen vorgegeben Wert hat. Im Ausführungsbeispiel ist dies ein "Blitzstatus", d.h. ein Losstatus, bei dem an diesem Los keine Messungen durchgeführt werden. Das Los wird sofort dem nächsten Schritt 410 des Herstellungsverfahrens zugeführt.

Gemäß dem Ablaufplan wird eine zweite Regel 411 des Regelwerkes überprüft. Die zweite Regel 411 ist eine Abfrage eines Samplingstatus des Loses. Hierunter wird z.B. ein Status des Loses verstanden, dass in einer allgemeinen Regel jedes vierte Los eines bestimmten Produktes A mittels einer Testmessung gemessen wird. Anhand des Ergebnisses der Abfrage wird das Los automatisch zu der nächsten Operation weitergeleitet. Im Falle, dass das Los z.B. ein jeweiliges viertes Los ist, wird es einer Testmessung 415 unterzogen und anhand des Ergebnisses dieser Testmessung 415 wird entschieden wie das betreffende Los weiter zu behandeln ist. Es kann wieder in den normalen Herstellungsprozess eingegliedert werden, d.h. zu Prozessschritt 410 weitergeleitet werden. Es kann aber auch einer Nachbearbeitung unterzogen oder aussortiert werden. Wenn das Los nicht das vierte Los ist, wird es ohne entsprechende Testmessung weiter prozessiert, d.h. eine nächsten Abfrage des Status des Loses wird durchgeführt.

Eine dritte Regel 412, der das Los unterzogen wird, betrifft eine Abfrage eines expliziten Losstatus des Loses an der Operation 408. Dies kann zum Beispiel ein Status sein, dass das spezielle Los genau an Operation 408 gemessen werden soll. Wenn solch ein Status gegeben ist, wird das Los einer Testmessung 416 unterzogen und anhand des Ergebnisses dieser Testmessung 416 wird entschieden wie das betreffende Los weiter zu behandeln ist. Es kann wieder in den normalen Herstellungsprozess eingegliedert werden, d.h. zu Prozessschritt 410 weitergeleitet werden. Es kann aber auch einer Nachbearbeitung unterzogen oder aussortiert werden. Wenn das Los keinen entsprechenden expliziten Losstatus aufweist, wird es ohne entsprechende Testmessung weiter prozessiert, d.h. eine nächsten Abfrage des Status des Loses wird durchgeführt.

Eine vierte Regel 413, der das Los unterzogen wird, betrifft eine Abfrage eines Sonderkontrollstatus. Dies kann zum Beispiel eine Regel sein, welche dazu führt, dass von jedem Los des Produktes A auf Operation 408 immer drei Wafer mittels eines bestimmten Programms einer Testmessung 417 unterzogen werden. Anhand des Ergebnisses dieser Testmessung 417 wird entschieden, wie das betreffende Los weiter zu behandeln ist. Es kann wieder in den normalen Herstellungsprozess eingegliedert werden, d.h. zu Prozessschritt 410 weitergeleitet werden. Es kann aber auch einer Nachbearbeitung unterzogen oder aussortiert werden. Wenn das Los keinen entsprechenden Sonderkontrollstatus aufweist, wird es ohne entsprechende Testmessung weiter prozessiert, d.h. zu Prozessschritt 410 weitergeleitet.

Im Ausführungsbeispiel wird nach Abarbeiten der beschriebenen vier Regeln, welche vier verschiedenen Regeltypen entsprechen, die nächste Operation (Prozessierungsschritt, Prozessschritt) 410 durchgeführt. Nach diesem nächsten Prozessierungsschritt 410 wird neben den schon oben beschriebenen Abfragetypen, welche hier nicht noch einmal beschrieben werden, auch ein zusätzlicher Abfragtyp durchgeführt. Der zusätzliche Abfragetyp bezieht sich auch auf den Samplingstatus des Loses, d.h. auf die Tatsache ob dieses Los als Stichprobe für Testmessungen ausgewählt wurde. Eine fünfte Regel 414 kann zum Beispiel eine Abfrage wie "Wenn das betreffende Los an Operation 408 nicht gemessen wurde, dieses Los auch nicht an Operation 410 messen" sein. Wenn dies der Fall ist, werden für das betreffende Los die weiteren Abfragen nach Prozessschritt 410 nicht durchgeführt und das Los wird unmittelbar weiterprozessiert.

Anders ausgedrückt, wenn im Ausführungsbeispiel die Auswertung der Abfrage 414 ein "Ja" ergibt, d.h. das betreffende Los an der Operation 408 keiner Testmessung unterzogen wurde, dann ergibt sich als Folge der Auswertung Schritt 418, d.h. für das betreffende Los wird bei vorgegebenen nächsten Prozessschritt (Prozessierungsschritt) eine zusätzliche Testmessung verhindert.

Wenn im Ausführungsbeispiel die Auswertung der Abfrage 414 ein "Nein" ergibt, d.h. das betreffende Los an der Operation 408 einer Testmessung unterzogen wurde, dann ergibt sich als Folge der Auswertung Schritt 419, d.h. für das betreffende Los wird eine zusätzliche Testmessung ermöglicht.

Der zusätzliche Abfragetyp wie er in der fünften Abfrage verwirklicht ist, ist vorzugsweise dazu geeignet, die Stichprobenauswahl zu beeinflussen, wenn Ergebnisse einer Testmessung nur im Zusammenhang mit den Ergebnissen einer vorangegangenen Testmessung, d.h. einer Testmessung, welche nach einem vorangegangenen Prozessierungsschritt durchgeführt wurden, ausgewertet werden können.

Der in Figur 4 gezeigte schematische Ablaufplan des erfindungsgemäßen Verfahrens ist so zu verstehen, dass die Auswertung mittels des Steuerrechners nach jedem Prozessschritt durchgeführt werden kann. D.h., dass nach dem Schritt 419 wieder Abfragen des in Schritt 409, 411, 412 und 413 dargestellten Typs durchgeführt werden können. In Figur 4 ist schematisch nur ein Teil des Verfahrens zum Überwachen eines Herstellungsprozesses dargestellt, welcher Teil nach jedem Prozessierungsschritt des Herstellungsverfahrens durchgeführt werden kann.

Im beschriebenen Ausführungsbeispiel gibt es mindestens fünf Regeln. Die oben beschriebenen fünf Regeln charakterisieren fünf Typen von Regeln. Weitere Regeln oder Regeltypen können hinzugefügt werden. Aber der minimale Satz von Regeltypen ist fünf. Je nach Ergebnis der Abfragen werden die Lose automatisch zu der entsprechenden Operation weitergeleitet, welche an dem entsprechenden Los vorgenommen werden soll, d.h. sie werden entweder einer Messung zum Überprüfen des Herstellungsprozesses und/oder der Produktionsqualität unterzogen, oder das Los durchläuft ohne Messung an dieser Operation den weiteren Herstellungsprozess.

Der in Fig. 4 schematisch dargestellte Ablauf ist nur ein Ausführungsbeispiel. Alternativ kann das Los, nachdem Testmessungen an ihm durchgeführt wurden auch anstelle weiterprozessiert zu werden, d.h. im obigen Beispiel zu Prozessschritt 410 weitergeleitet zu werden, auch den noch ausstehenden Abfragen unterworfen werden, d.h. dass ein Los, welches nach Abfrage 411 einer Testmessung 415 unterzogen wurde, nach der Testmessung 415 anstelle wie oben beschrieben direkt zu Prozessschritt 410 weitergeleitet zu werden, auch noch der Abfrage 412 und/oder 413 unterzogen werden kann.

Zusammenfassend schafft die Erfindung ein Verfahren zum Überwachen eines Herstellungsprozesses, bei welchem eine Stichprobenauswahl mittels eines automatischen Regelwerkes ausgeführt wird. Die Stichprobenauswahl wird nicht wie im Stand der Technik mittels Hantierungsanweisungen, z.B. Anweisungen für ganze Produktgruppen oder durch explizite Stopps z.B. für ausgesuchte Lose getätigt, sondern es wird ein Regelwerk aufgebaut, dessen Regeln global beeinflusst und/oder angepasst werden können. Mittels dieses Regelwerkes wird die Auswahl von Losen, Anzahl von Wafern und eventuell Wafernummern automatisch durchgeführt. Die verschiedenen Regeln des Regelwerkes werden gegenseitig abgeprüft, so dass es nicht zu redundanten Messungen oder übergangenen Messungen, d.h. Messungen, welche irrtümlich nicht durchgeführt werden, kommt. Ein minimaler Satz des Regelwerkes weist fünf verschiedene Regeltypen auf. Dieser minimale Satz kann jedoch je nach Bedarf erweitert werden.

In diesem Dokument sind folgende Dokumente zitiert:
[1] US 6 477 432
[2] US 6 148 239

### Bezugszeichenliste

- 100: schematisches Blockdiagramm eines Aufbaus einer Halbleiter-Produktionsanlage
- 101: Block eines gesamten Herstellungsprozesses
- 102: Block eines ersten Produktionsbereiches
- 103: Block eines zweiten Produktionsbereiches
- 104: Block eines dritten Produktionsbereiches
- 105: Block eines vierten Produktionsbereiches
- 200: Halbleiterchip-Produktionsanlage
- 201: Vielzahl von Halbleiterchip-Teil-Produktionsanlagen
- 202: Weg eines Wafers oder Loses durch die Halbleiterchip-Produktionsanlage
- 201: Maschine
- 301: Sensor
- 302: SECS-Schnittstelle
- 303: PDSF-Datei
- 304: Protokolldatei
- 306: lokales Kommunikationsnetz (LAN)
- 307: Speicher
- 408: Prozessierungsschritt
- 409: erste Regel
- 410: nächster Prozessierungsschritt
- 411: zweite Regel
- 412: dritte Regel
- 413: vierte Regel
- 414: fünfte Regel
- 415: Testmessung
- 416: Testmessung
- 417: Testmessung
- 418: Schritt des Verfahrens
- 419: weitere Schritt des Verfahrens

## Patentansprüche

1. Verfahren zum rechnergestützten Überwachen eines Herstellungsprozesses einer Mehrzahl von physikalischen Objekten,
bei dem mehrere Regeln gespeichert werden, welche sich auf zumindest einen Status mindestens eines der Mehrzahl von physikalischen Objekte beziehen;
bei dem unter Verwenden der Regeln eine Stichprobe aus der Mehrzahl von physikalischen Objekten ausgewählt wird, wobei physikalische Objekte der Stichprobe so markiert werden, dass sie einer Messung unterzogen werden können;
wobei die Regeln basierend auf dem Kriterium ausgestaltet sind, dass die Anzahl von Messungen reduziert wird und redundante Messungen vermieden werden; und
wobei die mehreren Regeln untereinander kombinierbar und gegeneinander abprüfbar sind.

2. Verfahren gemäß Anspruch 1, bei dem das physikalische Objekt ein Wafer ist.

3. Verfahren gemäß Anspruch 2, bei dem sich eine der mehreren gespeicherten Regeln auf einen SPC-Samplingstatus der Mehrzahl von physikalischen Objekten bezieht.

4. Verfahren gemäß Anspruch 2 oder 3, bei dem sich eine der mehreren gespeicherten Regeln auf eine Abfrage eines spezifischen Status der Mehrzahl von physikalischen Objekten bezieht.

5. Verfahren gemäß einem der Ansprüche 2 bis 4, bei dem sich eine der mehreren gespeicherten Regeln auf eine Abfrage eines expliziten Status der Mehrzahl von physikalischen Objekten an einem Prozessschritt bezieht.

6. Verfahren gemäß einem der Ansprüche 2 bis 5, bei dem sich eine der mehreren gespeicherten Regeln auf eine Abfrage eines Samplingstatus der Mehrzahl von physikalischen Objekten bezieht.

7. Verfahren gemäß einem der Ansprüche 2 bis 6, bei dem sich eine der mehreren gespeicherten Regeln auf eine Abfrage eines Sonderüberwachungsstatus der Mehrzahl von physikalischen Objekten bezieht.

8. Verfahren gemäß einem der Ansprüche 1 bis 7, bei dem die verschiedenen gespeicherten Regeln miteinander kombiniert werden.

9. Verfahren gemäß einem der Ansprüche 1 bis 8, bei dem die markierten physikalischen Objekte einer Messung unterzogen werden.

10. Vorrichtung zum rechnergestützten Überwachen eines Herstellungsprozesses einer Mehrzahl von physikalischen Objekten mit einem Prozessor, der derart eingerichtet ist, dass folgende Verfahrensschritte durchführbar sind:
Speichern mehrerer Regeln, wobei sich die mehreren Regeln auf zumindest einen Status mindestens eines der Mehrzahl von physikalischen Objekte bezieht; und
Auswählen einer Stichprobe aus der Mehrzahl von physikalischen Objekten unter Verwenden der zumindest einen Regel, wobei die Stichprobe so markiert wird, dass sie einer Messung unterzogen werden kann, wobei die Regeln basierend auf den Kriterium, dass die Anzahl von Messungen reduziert wird und redundante Messungen vermieden werden, ausgestaltet sind und wobei die mehreren Regeln untereinander kombinierbar sind und wobei die mehreren Regeln untereinander kombinierbar und gegeneinander abprüfbar sind.

11. Computerlesbares Speichermedium, in dem ein Programm zum Überwachen eines Herstellungsprozesses einer Mehrzahl von physikalischen Objekten gespeichert ist, das, wenn es von einem Prozessor ausgeführt wird, folgende Verfahrensschritte ausführt:
Speichern mehrerer Regeln, wobei sich die mehreren Regeln auf zumindest einen Status mindestens eines der Mehrzahl von physikalischen Objekte bezieht; und Auswählen einer Stichprobe aus der Mehrzahl von physikalischen Objekten unter Verwenden der zumindest einen Regel, wobei die Stichprobe so markiert wird, dass sie einer Messung unterzogen werden kann, wobei die Regeln basierend auf den Kriterium, dass die Anzahl von Messungen reduziert wird und redundante Messungen vermieden werden, ausgestaltet sind und wobei die mehreren Regeln untereinander kombinierbar sind und wobei die mehreren Regeln untereinander kombinierbar und gegeneinander abprüfbar sind.

12. Computerprogramm-Element zum Überwachen eines Herstellungsprozesses einer Mehrzahl von physikalischen Objekten, das, wenn es von einem Prozessor ausgeführt wird, folgende Verfahrensschritte ausführt:
Speichern mehrerer Regeln, wobei sich die mehreren Regeln auf zumindest einen Status mindestens eines der Mehrzahl von physikalischen Objekte bezieht; und Auswählen einer Stichprobe aus der Mehrzahl von physikalischen Objekten unter Verwenden der zumindest einen Regel, wobei die Stichprobe so markiert wird, dass sie einer Messung unterzogen werden kann, wobei die Regeln basierend auf den Kriterium, dass die Anzahl von Messungen reduziert wird und redundante Messungen vermieden werden, ausgestaltet sind und wobei die mehreren Regeln untereinander kombinierbar sind und wobei die mehreren Regeln untereinander kombinierbar und gegeneinander abprüfbar sind.
